# EUROPÄISCHE PATENTSCHRIFT

(11) **EP 1 105 924 B1**
(45) Veröffentlichungstag und Bekanntmachung des Hinweises auf die Patenterteilung: **07.03.2007**
(21) Anmeldenummer: 99945906.8
(22) Anmeldetag: 05.07.1999
(51) Int. Cl.: H01L 39/20

(54) **RESISTIVER KURZSCHLUSSSTROMBEGRENZER MIT EINER LEITERBAHNSTRUKTUR AUS HOCHTEMPERATUR-SUPRALEITERMATERIAL SOWIE VERFAHREN ZUR HERSTELLUNG DES STROMBEGRENZERS**
RESISTIVE SHORT-CIRCUIT CURRENT LIMITER WITH A PRINTED CONDUCTOR STRUCTURE MADE OF A HIGH-Tc SUPERCONDUCTIVE MATERIAL AND METHOD FOR PRODUCING SAID CURRENT LIMITER
LIMITEUR DE COURANT A COURT-CIRCUIT RESISTIF COMPORTANT UNE STRUCTURE A PISTE CONDUCTRICE CONSTITUEE D'UN MATERIAU SUPRACONDUCTEUR A POINT ELEVE DE CHANGEMENT BRUSQUE Tc, ET PROCEDE DE PRODUCTION D'UN TEL LIMITEUR DE COURANT

(30) Priorität: 17.07.1998 DE 19832274
(43) Veröffentlichungstag der Anmeldung: 13.06.2001
(73) Patentinhaber: SIEMENS AKTIENGESELLSCHAFT, 80333 München (DE)
(72) Erfinder: KRÄMER, Hans-Peter, D-91074 Herzogenaurach (DE); HEISMANN, Björn, D-91052 Erlangen (DE)
(86) Internationale Anmeldenummer: PCT/DE1999/002065
(87) Internationale Veröffentlichungsnummer: WO 2000/004589

(56) Entgegenhaltungen:
- PATENT ABSTRACTS OF JAPAN vol. 013, no. 232 (E-765), 29. Mai 1989 (1989-05-29) & JP 01 039229 A (TOSHIBA CORP), 9. Februar 1989 (1989-02-09)

## Beschreibung

Die Erfindung bezieht sich auf einen resistiven Kurzschlußstrombegrenzer mit einem zumindest teilweise aus elektrisch isolierendem Material bestehenden Trägerkörper, mit wenigstens einer auf dem Trägerkörper angeordneten Leiterbahnstruktur mit Hoch-T_{c}-Supraleitermaterial, die mindestens eine Leiterbahn mit mehreren ersten, im wesentlichen gradlinig verlaufenden Leiterbahnabschnitten und mit mehreren zweiten, nicht-geradlinig verlaufenden Leiterbahnabschnitten enthält, sowie mit Endstücken der Leiterbahnstruktur zu deren Kontaktierung mit Anschlußleitern. Die Erfindung betrifft ferner ein Verfahren zur Herstellung eines solchen Kurzschlußstrombegrenzers. Ein entsprechender Kurzschlußstrombegrenzer sowie ein Verfahren zu dessen Herstellung sind in der EP 0 523 374 A beschrieben. JP-A-01 039 229 offenbart einen Strombegrenzer mit einem supraleitenden Draht auf einem Trägerkörper. Der Draht weist bogenförmige Abschnitte auf.

In elektrischen Wechselstromversorgungsnetzen können Kurzschlüsse und elektrische Überschläge nicht mit Sicherheit vermieden werden. Dabei steigt der Wechselstrom im betroffenen Stromkreis sehr schnell, d.h. in der ersten Halbwelle des Stromes, auf ein Vielfaches seines Nennwertes an, bis er durch geeignete Sicherungs- und/oder-Schaltmittel unterbrochen wird. Als Folge davon treten in allen betroffenen Netzkomponenten wie Leitungen und Sammelschienen, Schaltern oder Transformatoren erhebliche thermische sowie mechanische Belastungen durch Stromkräfte auf. Da diese kurzzeitigen Lasten mit dem Quadrat des Stromes zunehmen, kann eine sichere Begrenzung des Kurzschlußstromes auf einen niedrigeren Spitzenwert die Anforderungen an die Belastungsfähigkeit dieser Netzkomponenten erheblich reduzieren. Dadurch lassen sich Kostenvorteile erzielen, etwa beim Aufbau neuer als auch beim Ausbau bestehender Netze, indem durch Einbau von Strombegrenzern ein Austausch von Netzkomponenten gegen höher belastbare Ausführungsformen vermieden werden kann.

Mit supraleitenden Kurzschlußstrombegrenzern vom resistiven Typ kann der Stromanstieg nach einem Kurzschluß auf einen Wert von wenigen Vielfachen des Nennstromes begrenzt werden; darüber hinaus ist ein solcher Begrenzer kurze Zeit nach Abschalten wieder betriebsbereit. Er wirkt also wie eine schnelle, selbstheilende Sicherung. Außerdem gewährleistet er eine hohe Betriebssicherheit, da er passiv wirkt, d.h. autonom ohne vorherige Detektion des Kurzschlusses und ohne aktive Auslösung durch ein Schaltsignal arbeitet.

Resistive supraleitende Kurzschlußstrombegrenzer der eingangs genannten Art bilden eine seriell in einen Stromkreis einzufügende supraleitende Schaltstrecke. Dabei wird der Übergang einer supraleitenden Leiterbahnstruktur dieses Begrenzers vom praktisch widerstandslosen kalten Betriebszustand unterhalb der Sprungtemperatur T_{c} des verwendeten Supraleitermaterials in den normalleitenden Zustand über T_{c} hinaus (sogenannter Phasenübergang) ausgenutzt, wobei der nun vorhandene elektrische Widerstand Rₙ der Leiterbahnstruktur den Strom auf eine akzeptable Höhe I=U/Rₙ begrenzt. Die Erwärmung über die Sprungtemperatur T_{c} geschieht dabei durch Joule'sche Wärme in dem Supraleitermaterial der Leiterbahnstruktur selbst, wenn nach Kurzschluß die Stromdichte j über den kritischen Wert j_{c} des Supraleitermaterials ansteigt, wobei das Material auch unterhalb der Sprungtemperatur T_{c} bereits einen endlichen elektrischen Widerstand aufweisen kann. Im begrenzenden Zustand oberhalb der Sprungtemperatur T_{c} fließt in dem den Kurzschlußstrombegrenzer enthaltenden Stromkreis ein Reststrom weiter, bis ein zusätzlicher mechanischer Trennschalter den Stromkreis völlig unterbricht.

Supraleitende Kurzschlußstrombegrenzer mit bekannten metalloxidischen Hoch-T_{c}-Supraleitermaterialien (Abkürzung: HTS-Materialien), deren Sprungtemperatur T_{c} so hoch liegt, daß sie mit flüssigem Stickstoff von 77 K im supraleitenden Betriebszustand zu halten sind, zeigen eine schnelle Zunahme des elektrischen Widerstandes beim Überschreiten der kritischen Stromdichte j_{c}. Die Erwärmung beim Übergang in den normalleitenden Zustand und somit die Strombegrenzung geschehen dabei in verhältnismäßig kurzer Zeit, so daß der Spitzenwert des Kurzschlußstromes auf einen Bruchteil des unbegrenzten Stromes, etwa auf den 3- bis 10-fachen Nennstrom begrenzt werden kann. Der supraleitende Strompfad des Kurzschlußstrombegrenzers ist dabei im Kontakt mit einem Kühlmittel, das ihn in verhältnismäßig kurzer-Zeit nach einem Überschreiten der kritischen Stromdichte j_{c} in den supraleitenden Betriebszustand zurückzuführen vermag.

Der aus der eingangs genannten EP-A-Schrift zu entnehmende, entsprechend arbeitende resistive Kurzschlußstrombegrenzer enthält eine Leiterbahnstruktur in Form eines mäanderförmig gewundenen elektrischen Leiters aus einem HTS-Material, der beispielsweise aus einer 5 mm dicken Platte aus dem HTS-Material mittels seitlichen Schlitzen herausgearbeitet ist. Der Leiter setzt sich deshalb aus ersten, praktisch geradlinig verlaufenden und untereinander parallelen Leiterbahnabschnitten und quer dazu verlaufenden, diese geradlinigen Leiterbahnabschnitte verbindenden Leiterbahnabschnitten zusammen. Im gegenseitigen Verbindungsbereich am Ende der ersten, geradlinigen Leiterbahnabschnitte bildet somit der Leiter eine geknickt bzw. abgewinkelte Leiterbahn, die dort als ein zweiter, nicht-geradlinig verlaufender Leiterbahnabschnitt angesehen werden kann. Der gesamte Leiter kann selbsttragend ausgebildet sein; er kann sich jedoch zur Erhöhung seiner mechanischen Stabilität auch auf einem Trägerkörper befinden. Die Endstücke des Leiters sind als Kontaktstücke ausgebildet, an die externe Anschlußleiter zum Zweck der Einspeisung des zu begrenzenden Stromes anzuschließen sind.

Bei einem derartigen supraleitenden Kurzschlußstrombegrenzer tritt das Problem auf, daß sich an den Knickstelleh der Leiterbahn zwischen einem geradlinig verlaufenden (ersten) Leiterbahnabschnitt und den dazu quer verlaufenden, solche geradlinigen Leiterbahnabschnitte verbindenden Leiterbahnabschnitt die Stromverteilung und damit die Wärmebelastung im Begrenzungsfall inhomogen sind. Man sah sich deshalb bisher gezwungen, die Leiterbahn bekannter Kurzschlußstrombegrenzer nur für entsprechend geringere Schaltleistungen einzusetzen; oder man mußte die nicht-geradlinigen (zweiten) Leiterbahnabschnitte so überdimensionieren, daß sie keine unerwünschte Leistungsbegrenzungsfunktion hatten. Im letzteren Fall war dann aber die Flächenausnutzung der Oberfläche des Trägerkörpers entsprechend ungünstig.

Aufgabe der vorliegenden Erfindung ist es deshalb, den Kurzschlußstrombegrenzer der eingangs genannten Art dahingehend auszugestalten, daß mit ihm eine vergleichsweise höhere maximale Schaltleistung ermöglicht wird, ohne daß eine Überdimensionierung von Leiterbahnabschnitten erforderlich wäre. Au-ßerdem soll ein Verfahren zu einer möglichst einfachen Herstellung eines solchen Begrenzers angegeben werden.

Diese Aufgabe wird bezüglich des Kurzschlußstrombegrenzers erfindungsgemäß dadurch gelöst, daß alle zweiten, nicht-geradlinig verlaufenden Leiterbahnabschnitte bogenförmig gestaltet sind mit einem maximalen Radienverhältnis v = r_{a/}rᵢ von 7, wobei rₐ der Außenradius und rᵢ der Innenradius des jeweiligen bogenförmigen Leiterbahnabschnittes sind. Übergangsstücke oder Endstücke an den Enden der mindestens einen Leiterbahn zur Kontaktierung mit Anschlußleitern sollen dabei in die erfindungsgemäße Bemessung des maximalen Radienverhältnisses nicht mit einbezogen sein.

Die mit dieser Ausgestaltung des Kurzschlußstrombegrenzers verbundenen Vorteile sind insbesondere darin zu sehen, daß bei Einhaltung des angegebenen geometrischen Kriteriums für die zweiten, bogenförmigen Leiterbahnabschnitte die inhomogene lokale Belastung auf ein tolerierbares Maß reduziert wird, ohne daß die Flächenausnutzung wesentlich verschlechtert würde. Die Temperaturüberhöhung am Innenradius relativ zum Au-ßenradius T(rᵢ)/T(rₐ) beim Schalten des entsprechenden Leiterbahnabschnittes wird nämlich auf maximal v² begrenzt.

Vorzugsweise wird ein maximales Radienverhältnis v=rₐ/rᵢ von 6, insbesondere von 5 gewählt. Bei diesen Werten ist die Gefahr einer unerwünschten Temperaturerhöhung bei üblichen Leiterbahnbreiten praktisch auszuschließen.

Aus Gründen einer guten Flächenausnutzung ist es besonders günstig, wenn alle zweiten, bogenförmigen Leiterbahnabschnitte dabei ein (minimales) Radienverhältnis v von mindestens 2,5, vorzugsweise von mindestens 3 aufweisen. Kleinere Werte von v und damit größere Innenradien verringern zwar die Temperaturüberhöhung, verschlechtern aber auch die Flächenausnutzung.

Aus denselben Gründen weisen vorteilhaft alle zweiten, bogenförmigen Leiterbahnabschnitte zumindest annähernd dieselbe Leiterbahnbreite auf wie die ersten, geradlinigen Leiterbahnabschnitte.

Ein Bereich des Radienverhältnisses v aller zweiten Leiterbahnabschnitte zwischen 3 und 6 stellt folglich für die Praxis einen guten Kompromiß zwischen Temperaturüberhöhung und Flächenausnutzung dar.

Vorteilhaft wird für den erfindungsgemäßen Kurzschlußstrombegrenzer, insbesondere wenn es um einen großflächigen Aufbau geht, ein Trägerkörper aus einem speziellen Glasmaterial gewählt.

Ein vorteilhaftes Verfahren zur Herstellung eines erfindungsgemäßen Kurzschlußstrombegrenzers ist dadurch gekennzeichnet, daß die mindestens eine Leiterbahn mittels Strukturierung mindestens einer auf den Trägerkörper direkt oder indirekt aufgebrachten Schicht aus dem Hoch-T_{c}-Supraleitermaterial ausgebildet wird. Mit an sich bekannten physikalischen oder mechanischen Strukturierungsprozessen lassen die einzelnen Leiterbahnabschnitte auf verhältnismäßig einfache Weise ausbilden.

Weitere vorteilhafte Ausgestaltungen des erfindungsgemäßen Kurzschlußstrombegrenzers bzw. des Verfahrens zu dessen Herstellung gehen aus den jeweils abhängigen Ansprüchen hervor.

Ausführungsbeispiele der Leiterbahnstrukturen von erfindungsgemäßen Kurzschlußstrombegrenzern werden nachfolgend anhand der Zeichnung noch näher erläutert. Dabei zeigen jeweils schematisch deren
- Figur 1: einen Querschnitt durch einen Teil eines solchen Kurzschlußstrombegrenzers
und deren
- Figuren 2 bis 4: jeweils in Aufsicht verschiedene Ausgestaltungsmöglichkeiten von Leiterbahnstrukturen eines solchen Kurzschlußstrombegrenzers.

In den Figuren sind sich entsprechende Teile mit denselben Bezugszeichen versehen.

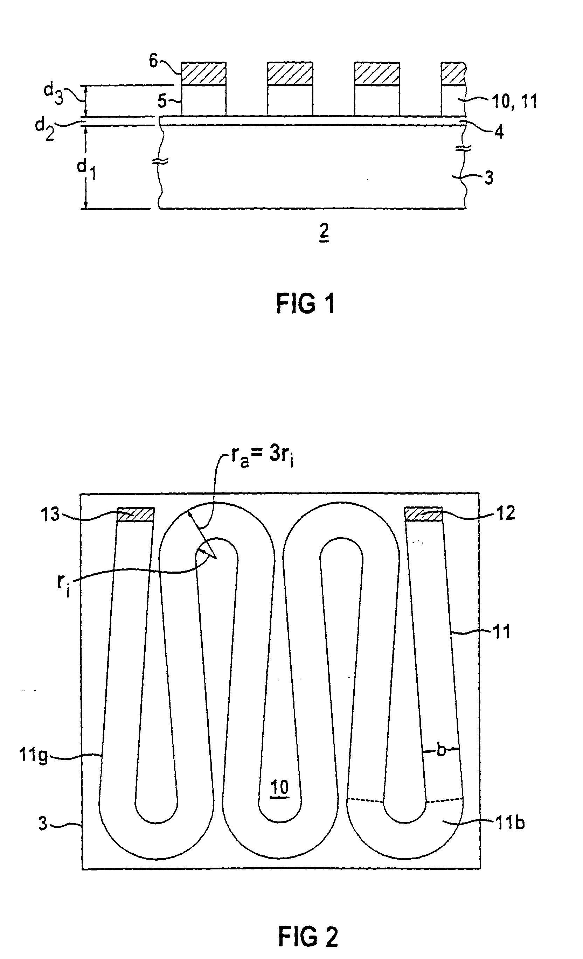

Bei dem erfindungsgemäßen Kurzschlußstrombegrenzer wird von an sich bekannten Ausführungsformen solcher Begrenzer ausgegangen (vgl, z.B. die eingangs genannte EP-A-Schrift oder die *DE 195 20 205 A).* Der prinzipielle Aufbau des Begrenzers ist in Figur 1 als Ausschnitt aus einem Querschnitt durch den wesentlichsten Teil eines solchen Begrenzers angedeutet. Dieser Aufbau des allgemein mit 2 bezeichneten Begrenzers umfaßt dabei einen Trägerkörper 3 mit einer Dicke d₁ und gegebenenfalls mindestens eine darauf aufgebrachte Zwischenschicht 4 mit einer Dicke d₂. Diese Zwischenschicht sei nachfolgend als Teil des Trägerkörpers angesehen. Auf sie ist eine Schicht 5 aus einem HTS-Material mit einer Dicke d₃ aufgebracht bzw. abgeschieden, die erfindungsgemäß strukturiert ist. Die HTS-Schicht kann mit mindestens einer weiteren Deckschicht wie z.B. einer Schutzschicht oder einer vorzugsweise als Shuntwiderstand dienenden Schicht 6 abgedeckt sein. Eine Shuntwiderstandschicht aus Metall ist für Strombegrenzeranwendungen insbesondere im Falle einer Verwendung eines isolierenden Trägerkörpers besonders vorteilhaft.

Der Trägerkörper 3 kann durch einen planaren oder gegebenenfalls auch durch einen gekrümmten wie z.B. rohrförmigen Substratkörper gebildet sein. Er besteht zumindest teilweise aus einem elektrisch isolierenden Material. Hierfür geeignete Materialien sind Keramiken wie z.B. MgO, SrTiO₃, Al₂O₃ oder mit Y-stabilisiertes ZrO₂ (Abkürzung: YSZ). Besonders vorteilhaft werden Trägerkörper aus speziellen Glasmaterialien vorgesehen, insbesondere wenn es um großflächige Leiterbahnstrukturen geht. Eine entsprechende Platte aus einem besonderen Flachglas kann beispielsweise eine Dicke d₁ von einigen Millimetern haben. Daneben sind auch aus metallischem und darauf elektrisch isolierendem Material zusammengesetzte Trägerkörper geeignet. Insbesondere im Falle einer Verwendung von metallischen Teilen für den Trägerkörper ist die Zwischenschicht 5 aus einem elektrisch isolierenden Material erforderlich. Eine solche Zwischenschicht kann auch als sogenannte Pufferschicht benötigt werden, um einerseits eine Wechselwirkung zwischen dem auf sie aufzubringenden HTS-Material und dem Trägerkörpermaterial zu unterbinden und andererseits eine Textur des aufzubringenden HTS-Materials zu fördern. Bekannte Pufferschichtmaterialien, die im allgemeinen in einer Dicke d₂ zwischen 0,1 und 2 µm aufgebracht werden, sind YSZ, YSZ+CeO₂ (als Doppelschicht), YSZ+Sn-dotiertes In₂O₃ (als Doppelschicht), CeO₂, Pr₆O₁₁, MgO, SrTiO₃ oder La₁₋ₓCaₓMnO₃.

Als HTS-Materialien für die Schicht 5 kommen alle bekannten metalloxidischen Hoch-T_{c}-Supraleitermaterialien wie insbesondere YBa₂Cu₃O₇₋ₓ bzw. RBa₂Cu₃O₇₋ₓ (mit R = seltenes Erdmetall), TlBa₂Ca₂Cu₃O₉₊ₓ, HgBa₂CaCu₂O₆₊ₓ, Bi₂Sr₂CaCu₂O₈₊ₓ oder (Bi,Pb)₂Sr₂Ca₂Cu₃O₁₁₋ₓ in Frage. Selbstverständlich können von diesen Materialien einzelne oder mehrere Komponenten durch andere Elemente in an sich bekannter Weise teilweise oder vollständig substituiert sein. Die HTS-Schicht wird mit an sich bekannten Verfahren auf dem Trägerkörper 3 bzw. der ihn abdeckenden Zwischenschicht 4 mit einer Dicke d₃ von bis zu einigen µm aufgebracht.

Wie in Figur 1 ferner angedeutet ist, soll zumindest die HTS-Schicht 5 in besonderer Weise zu einer Leiterbahnstruktur 10 gestaltet sein. Hierfür kommen alle bekannten physikalischen oder auch chemischen Strukturierungsprozesse in Frage. Beispielsweise kann die Strukturierung mittels eines Lasers vorgenommen werden.

Eine Gestaltungsmöglichkeit der Leiterbahnstruktur 10 ist in Figur 2 in Aufsicht dargestellt. Diese Leiterbahnstruktur wird durch eine mäanderförmige Leiterbahn 11 gebildet, die sich aus ersten, zumindest weitgehend geradlinig verlaufenden Leiterbahnabschnitten 11g und zweiten, bogenförmig gestalteten Leiterbahnabschnitten 11b zusammensetzt. An ihren Enden ist die Leiterbahn als Endstücke 12 und 13 gestaltet, die mit Anschlußleitern zu kontaktieren sind.

Gemäß der Erfindung sollen alle bogenförmigen Leiterbahnabschnitte 11b ein besonderes geometrisches Kriterium erfüllen. Dieses Kriterium wird durch ein maximales Radienverhältnis v = rₐ/rᵢ bestimmt, wobei rₐ der Außenradius und rᵢ der Innenradius des jeweiligen bogenförmigen Abschnittes sind. D.h., jeder bogenförmige Leiterbahnabschnitt soll ein Radienverhältnis v aufweisen, dessen Wert höchstens der genannte Maximalwert ist (oder darunter). Dabei wird vorteilhaft davon ausgegangen, daß die Leiterbahn 11 im Bereich ihrer bogenförmigen Leiterbahnabschnitte 11b zumindest annähernd, vorzugsweise dieselbe Breite b aufweist wie im Bereich der gradlinigen Leiterbahnabschnitte 11g, so daß gilt: rₐ - rᵢ = b. Bei vorgegebener Leiterbahnbreite b ist dann das Kriterium gleichbedeutend mit der Einführung eines Mindestinnenradius r_{i,m,in}, da v = 1 + b/r_{i,min} ist. Dieses Kriterium gewährleistet, daß die Temperaturüberhöhung T (rᵢ) /T (rₐ) am Innenradius rᵢ relativ zum Außenradius rₐ beim Schalten des bogenförmigen Leiterbahnabschnittes auf maximal v² begrenzt wird. Dabei verringern zwar kleinere Werte von v und damit größere Innenradien die Temperaturüberhöhung, verschlechtern aber auch die Flächenausnutzung der Belegung der Oberfläche des Trägerkörpers 3 mit Supraleitermaterial. Es hat sich gezeigt, daß Werte von v zwischen 2,5 und 7, insbesondere zwischen 3 und 6, einen guten Kompromiß zwischen Temperaturüberhöhung und Flächenausnutzung darstellen. Aus diesem Grunde soll erfindungsgemäß ein Wert v = 7 als maximales Radienverhältnis nicht überschritten werden und wird vorzugsweise ein Wert v von maximal 6, insbesondere von maximal 5 gewählt. Ein kleineres v als 2,5 für alle zweiten, gebogenen Leiterbahnabschnitte ist weniger zweckmäßig. Bei der in Figur 2 gezeigten Ausführungsform der Leiterbahnstruktur 10 ist v = 3.

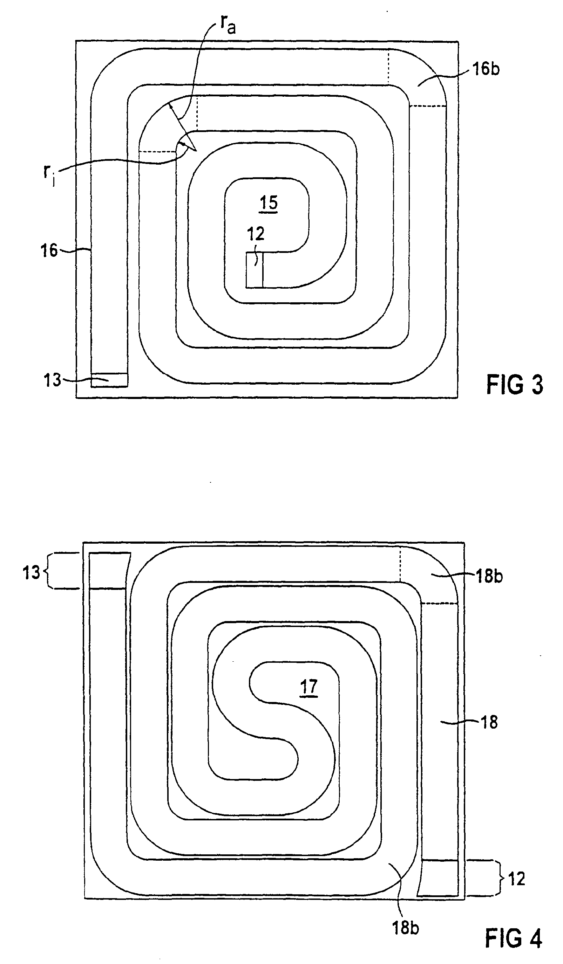

Auch bei den in den Figuren 3 und 4 angedeuteten Ausführungsformen von Leiterbahnstrukturen 15 bzw. 17 ist ein maximales Radienverhältnis v von 3 für gebogene Leiterbahnabschnitte 16b bzw. 18b ihrer Leiterbahnen 16 bzw. 18 vorgesehen. Dabei beschreibt die Leiterbahn 16 nach Figur 3 eine von außen nach innen laufende Spiralform mit einem zentralen Endstück 12 und einem außenliegenden Endstück 13. Die in Figur 4 gezeigte Leiterbahn 18 beschreibt eine von außen nach innen und wieder zurück nach außen führende Spiralform, so daß ihre Endstücke 12 und 13 jeweils außen zu liegen kommen.

Bei den anhand der Figuren erläuterten Ausführungsformen von Kurzschlußstrombegrenzern nach der Erfindung wurde davon ausgegangen, daß deren Leiterbahnstrukturen jeweils nur einseitig auf einem Trägerkörper aufgebracht sind. Selbstverständlich ist auch ein beidseitiges Belegen der gegenüberliegenden Flächen des Trägerkörpers mit einer einzigen oder auch mit mehreren Leiterbahnstrukturen möglich.

## Patentansprüche

1. Resistiver Kurzschlußstrombegrenzer mit
- einem zumindest teilweise aus elektrisch isolierendem Material bestehenden Trägerkörper,
- wenigstens einer auf dem Trägerkörper angeordneten Leiterbahnstruktur mit Hoch-T_{c}-Supraleitermaterial, die mindestens eine Leiterbahn mit mehreren ersten, im wesentlichen geradlinig verlaufenden Leiterbahnabschnitten und mit mehreren zweiten, nicht-geradlinig verlaufenden Leiterbahnabschnitten enthält,
sowie
- Endstücken der Leiterbahnstruktur zu deren Kontaktierung mit Anschlußleitern,
**dadurch gekennzeichnet, daß** alle zweiten, nicht-geradlinig verlaufenden Leiterbahnabschnitte (11b, 16b, 18b) bogenförmig gestaltet sind mit einem maximalen Radienverhältnis v = rₐ/rᵢ von 7, wobei rₐ der Außenradius und rᵢ der Innenradius des jeweiligen bogenförmigen Leiterbahnabschnittes sind.

2. Kurzschlußstrombegrenzer nach Anspruch 1, **gekennzeichnet durch** ein maximales Radienverhältnis v von 6, vorzugsweise von 5.

3. Kurzschlußstrombegrenzer nach Anspruch 1 oder 2, **dadurch gekennzeichnet, daß** alle zweiten Leiterbahnabschnitte (11b, 16b, 18b) ein Radienverhältnis v = rₐ/rᵢ von mindestens 2,5, vorzugsweise von mindestens 3 aufweisen.

4. Kurzschlußstrombegrenzer nach Anspruch 3, **gekennzeichnet durch** ein Radienverhältnis v aller zweiten Leiterbahnabschnitte (11b, 16b, 18b) zwischen 3 und 6.

5. Kurzschlußstrombegrenzer nach einem der Ansprüche 1 bis 4,
**dadurch gekennzeichnet, daß** alle zweiten Leiterbahnabschnitte (11b, 16b, 18b) zumindest annähernd dieselbe Leiterbahnbreite (b) aufweisen, wie die ersten Leiterbahnabschnitte (11g).

6. Kurzschlußstrombegrenzer nach einem der Ansprüche 1 bis 5,
**dadurch gekennzeichnet, daß** der Trägerkörper (3) aus einem keramischen Material oder aus einem Glasmaterial besteht.

7. Kurzschlußstrombegrenzer nach einem der Ansprüche 1 bis 6,
**dadurch gekennzeichnet, daß** der Trägerkörper (3) mit mindestens einer Zwischenschicht (4) als Unterlage für die Leiterbahnstruktur (10, 15, 17) versehen ist.

8. Kurzschlußstrombegrenzer nach einem der Ansprüche 1 bis 7,
**dadurch gekennzeichnet, daß** die Leiterbahnstruktur (10) von wenigstens einer weiteren Schicht (6) abgedeckt ist.

9. Kurzschlußstrombegrenzer nach Anspruch 8, **dadurch gekennzeichnet, daß** die abdeckende Schicht (6) eine als Shuntwiderstand wirkende Metallschicht ist.

10. Kurzschlußstrombegrenzer nach einem der Ansprüche 1 bis 9, **dadurch gekennzeichnet, daß** der Trägerkörper (3) beidseitig mit mindestens einer Leiterbahnstruktur versehen ist.

11. Verfahren der Herstellung des Strombegrenzers nach einem der Ansprüche 1 bis 10, wobei die mindestens eine Leiterbahn (11, 16, 18) mittels Strukturierung mindestens einer auf dem Trägerkörper (3) direkt oder indirekt aufgebrachten Schicht (5) aus dem Hoch-T_{c}-Supraleitermaterial ausgebildet wird.

12. Verfahren nach Anspruch 11, **dadurch gekennzeichnet, daß** zur Strukturierung ein physikalischer oder chemischer Strukturierungsprozeß vorgesehen wird.

## Claims

1. Resistive short-circuit current limiter having
- a support body which is at least partially composed of electrically insulating material,
- at least one conductor track structure with high-T_{c} superconductor material, which structure is arranged on the support body and contains at least one conductor track having a plurality of first conductor track sections extending essentially rectilinearly and having a plurality of second conductor track sections extending non-rectilinearly, and also
- end pieces of the conductor track structure for the latter to make contact with connecting conductors,
**characterized in that** all the second conductor track sections (11b, 16b, 18b) extending non-rectilinearly are configured arcuately with a maximum radii ratio v = rₐ/rᵢ of 7, where rₐ is the external radius and rᵢ the internal radius of the respective arcuate conductor track section.

2. Short-circuit current limiter according to claim 1,
**characterized by** a maximum radii ratio v of 6, preferably of 5.

3. Short-circuit current limiter according to claim 1 or 2,
**characterized in that** all the second conductor track sections (11b, 16b, 18b) have a radii ratio v = r_{a/}rᵢ of at least 2.5, preferably of at least 3.

4. Short-circuit current limiter according to claim 3, **characterized by** a radii ratio v of all the second conductor track sections (11b, 16b, 18b) of between 3 and 6.

5. Short-circuit current limiter according to one of claims 1 to 4, **characterized in that** all the second conductor track sections (11b, 16b, 18b) have at least approximately the same conductor track width (b) as the first conductor track sections (11g).

6. Short-circuit current limiter according to one of claims 1 to 5, **characterized in that** the support body (3) is composed of a ceramic material or of a glass material.

7. Short-circuit current limiter according to one of claims 1 to 6, **characterized in that** the support body (3) is provided with at least one intermediate layer (4) as base for the conductor track structure (10, 15, 17).

8. Short-circuit current limiter according to one of claims 1 to 7, **characterized in that** the conductor track structure (10) is covered by at least one further layer (6).

9. Short-circuit current limiter according to claim 8, **characterized in that** the covering layer (6) is a metal layer acting as a shunt resistor.

10. Short-circuit current limiter according to one of claims 1 to 9, **characterized in that** the support body (3) is provided with at least one conductor track structure on both sides.

11. Method of producing the current limiter according to one of claims 1 to 10, in which the at least one conductor track (11, 16, 18) is formed by patterning at least one layer (5) which is made of the high-T_{c} superconductor material and is applied directly or indirectly on the support body (3).

12. Method according to claim 11, **characterized in that** a physical or chemical patterning process is provided for the patterning.

## Revendications

1. Limiteur de courant à court-circuit résistif comprenant
- un corps support constitué au moins en partie d'un matériau isolant du point de vue électrique,
- au moins une structure de piste conductrice qui est disposée sur le corps support, qui a un matériau supraconducteur à haute T_{c} et qui comporte au moins une piste conductrice ayant plusieurs premiers tronçons s'étendant sensiblement en ligne droite et plusieurs deuxièmes tronçons de piste conductrice ne s'étendant pas en ligne droite,
ainsi que
- des embouts de la structure de piste conductrice pour sa mise en contact avec des conducteurs de connexion,
**caractérisé en ce que** tous les deuxièmes tronçons (11b, 16b, 18b) de piste conductrice qui ne s'étendent pas en ligne droite sont arqués en ayant un rapport maximum de rayon v = rₐ/rᵢ de 7, rₐ étant le rayon extérieur et rᵢ le rayon intérieur du tronçon de piste conductrice arqué respectif.

2. Limiteur de courant à court-circuit suivant la revendication 1, **caractérisé par** un rapport de rayon maximum v de 6, de préférence de 5.

3. Limiteur de courant à court-circuit suivant la revendication 1 ou 2, **caractérisé en ce que** tous les deuxièmes tronçons (11b, 16b, 18b) de piste conductrice ont un rapport de rayon v = rₐ/rᵢ d'au moins 2,5, de préférence d'au moins 3.

4. Limiteur de courant à court-circuit suivant la revendication 3, **caractérisé par** un rapport de rayon v de tous les deuxièmes tronçons (11b, 16b, 18b) de piste conductrice compris entre 3 et 6.

5. Limiteur de courant à court-circuit suivant l'une des revendications 1 à 4, **caractérisé en ce que** tous les deuxièmes tronçons (11b, 16b, 18b) de piste conductrice ont au moins à peu près la même largeur (b) de piste conductrice que les premiers tronçons (11g) de piste conductrice.

6. Limiteur de courant à court-circuit suivant l'une des revendications 1 à 5, **caractérisé en ce que** le corps (3) support est en un matériau céramique ou en un matériau en verre.

7. Limiteur de courant à court-circuit suivant l'une des revendications 1 à 6, **caractérisé en ce que** le corps (3) support est muni d'au moins une couche (4) intermédiaire servant de couche sous-jacente pour la structure (10, 15, 17) de piste conductrice.

8. Limiteur de courant à court-circuit suivant l'une des revendications 1 à 7, **caractérisé en ce que** la structure (10) de piste conductrice est revêtue d'au moins une autre couche (6).

9. Limiteur de courant à court-circuit suivant la revendication 8, **caractérisé en ce que** la couche (6) de revêtement est une couche métallique servant de résistance shunt.

10. Limiteur de courant à court-circuit suivant l'une des revendications 1 à 9, **caractérisé en ce que** le corps (3) support est muni des deux côtés d'au moins une structure de piste conductrice.

11. Procédé de production du limiteur de courant à court-circuit suivant l'une des revendications 1 à 10, qui est formé d'au moins une piste (11, 16, 18) conductrice au moyen d'une structuration d'au moins une couche (5) en un matériau supraconducteur à haute T_{c} déposé directement ou indirectement sur le corps (3) support.

12. Procédé suivant la revendication 11, **caractérisé en ce que** l'on prévoit un processus de structuration physique ou chimique pour la structuration.
